# EUROPÄISCHE PATENTSCHRIFT

(11) **EP 2 830 402 B1**
(45) Veröffentlichungstag und Bekanntmachung des Hinweises auf die Patenterteilung: **29.07.2020**
(21) Anmeldenummer: 14162713.3
(22) Anmeldetag: 31.03.2014
(51) Int. Cl.: H05K 7/14, H02M 7/00

(54) **Frequenzumrichter**
Frequency inverter
Convertisseur de fréquence

(30) Priorität: 03.04.2013 DE 102013205898
(43) Veröffentlichungstag der Anmeldung: 28.01.2015
(73) Patentinhaber: Lenze Drives GmbH, 32699 Extertal (DE)
(72) Erfinder: Büscher, Fabian, 32657 Lemgo (DE); Hübner, Karsten, 31855 Aerzen (DE); Hüskes, Rudi, 31020 Salzhemmendorf (DE)
(74) Vertreter: Patentanwälte Ruff, Wilhelm, Beier, Dauster & Partner mbB

(56) Entgegenhaltungen:
- EP-A1- 1 995 861
- EP-A1- 2 639 943
- EP-A2- 1 134 882
- EP-A2- 1 176 706
- DE-A1- 19 928 400
- DE-A1-102011 010 431
- DE-U1- 29 609 183
- US-A- 5 930 112

## Beschreibung

Die Erfindung betrifft einen Frequenzumrichter.

Bei der Inbetriebnahme von Frequenzumrichtern im Feld ist es unter Umständen notwendig, von außen zugeführte elektrische Anschlussleitungen innerhalb des Frequenzumrichters an Klemm- und/oder Steckverbinder des Frequenzumrichters anzuschließen. Im Zuge dieser Arbeiten besteht die Gefahr, dass Bereiche mit gefährdenden Spannungen berührt werden.

Die nicht vorveröffentlichte EP 2 639 943 A1 zeigt einen Elektromotor mit einem Elektronikgehäuse, welches einen abnehmbaren Deckel sowie eine Bedieneinheit aufweist.

Die DE 199 28 400 A1 zeigt eine berührungssichere elektrische Hochspannungsversorgung, die ein erstes Gehäuseteil aufweist, das zur äußeren Abdeckung dient. Weiter ist ein zweites zwei Seiten bildendes Gehäuseteil vorgesehen, auf dessen erster Seite ein Hochspannungsversorgungsteil und auf dessen zweiter Seite ein Niederspannungsversorgungsteil, von dem Hochspannungsversorgungsteil räumlich getrennt, angeordnet sind.

Die US 5,930,112 A zeigt eine drahtlose Motorsteuereinheit.

Die DE 10 2011 010 431 A1 zeigt einen Frequenzumrichter mit einer Leiterplatte, die zumindest teilweise von einem Kunststoffkörper umgeben ist und mit diesem stoff- und/oder formschlüssig verbunden ist. Dadurch ist die Leiterplatte vor mechanischen Einwirkungen, wie Kraftstößen, Erschütterungen oder dergleichen geschützt.

Die EP 1 176 706 A2 zeigt einen Frequenzumrichter mit einem Oberteil und einem Unterteil.

Der Erfindung liegt die Aufgabe zugrunde, einen Frequenzumrichter zur Verfügung zu stellen, der eine Berührung von Bereichen mit gefährdenden Spannungen verhindert und der einfach montierbar und demontierbar ist.

Die Erfindung löst diese Aufgabe durch einen Frequenzumrichter nach Anspruch 1. Bevorzugte Ausführungsformen sind Gegenstand der Unteransprüche.

Der Frequenzumrichter weist mindestens eine Leiterplatte mit gegenüber Berührung zu schützenden Bereichen auf, d.h. Bereichen, die möglicherweise gesundheitsgefährdende Spannungen führen und/oder empfindlich gegenüber ESD (elektrostatische Entladung) sind.

Der Frequenzumrichter weist weiter einen räumlich geformten Kunststoffformkörper mit, insbesondere werkzeuglos, bedienbaren Haltemitteln auf. Die Haltemittel sind dazu ausgebildet, die Leiterplatte im Kunststoffformkörper lösbar mechanisch zu fixieren bzw. zu halten und/oder zu stützen, wobei die gegenüber Berührung zu schützenden Bereiche der Leiterplatte bei im Kunststoffformkörper fixierter Leiterplatte zumindest auf einer Leiterplattenseite derart durch den Kunststoffformkörper überdeckt sind, dass eine Berührung durch eine Hand bzw. einen Finger verhindert wird. Der Kunststoffformkörper dient folglich einerseits als Berührschutz und andererseits als mechanische Aufnahme und Fixierung der Leiterplatte, die die Leiterplatte derart mechanisch fixiert, dass diese beispielsweise nicht zusätzlich mechanisch an einem Gehäuse fixiert werden muss.

Der Frequenzumrichter weist weiter ein Gehäuse auf, in dem der Kunststoffformkörper sowie die im Kunststoffformkörper fixierte Leiterplatte angeordnet sind. Aufgrund der Fixierung der Leiterplatte durch die Haltemittel im Kunststoffformkörper entfällt die Notwendigkeit, die Leiterplatte mit dem Gehäuse mechanisch zu verbinden. Dies reduziert den Montageaufwand. Weiter kann die Anzahl der Haltemittel derart groß gewählt werden, dass eine sichere mechanische Fixierung an sämtlichen relevanten Bereichen der Leiterplatte möglich ist, ohne dass hierzu beispielsweise eine entsprechend große Anzahl an Verschraubungen vorgesehen werden muss.

Die Haltemittel können jeweils einen Rastmechanismus bzw. Rastmitel aufweisen. Beispielsweise kann die Leiterplatte in eine hierfür vorgesehene Öffnung des Kunststoffformkörpers eingeschoben bzw. eingedrückt werden, wobei der jeweilige Rastmechanismus der Haltemittel ein verrastendes Fixieren der Leiterplatte ab einer bestimmten Einschubposition bewirkt.

Auf der Leiterplatte kann mindestens ein lösbarer Klemm- oder Steckverbinder oder dergleichen angeordnet sein, wobei die Haltemittel derart angeordnet sind, dass sie die Leiterplatte spezifisch im Bereich des mindestens einen Klemm- oder Steckverbinders mechanisch fixieren bzw. unterstützen, um ungewollte Verformungen bei einer Kraftbeaufschlagung im Zuge eines Klemm- oder Steckvorgangs zu verhindern.

Die Haltemittel können derart ausgebildet sein, dass ein Lösen der Leiterplatte aus dem Kunststoffformkörper nur dann möglich ist, wenn der Kunststoffformkörper sowie die im Kunststoffformkörper fixierte Leiterplatte nicht in das Gehäuse eingesetzt sind.

Der Kunststoffformkörper kann derart ausgebildet sein, dass die Klemm- oder Steckverbinder für einen Benutzer zugänglich sind. Der Kunststoffformkörper kann hierzu beispielsweise entsprechende Öffnungen bzw. Aussparungen aufweisen.

Der Kunststoffformkörper kann Funktionsmodulhaltemittel aufweisen, die dazu ausgebildet sind, Funktionsmodule, die von der Leiterplatte mechanisch getrennt vorgesehen sind, mechanisch an einer vorgegebenen Position zu fixieren.

Die Funktionsmodulhaltemittel können Führungsmittel aufweisen, die dazu ausgebildet sind, einen oder mehrere Kontaktstifte des Funktionsmoduls derart mechanisch zu führen, dass zugehörige Kontaktbereiche der Leiterplatte, beispielswiese im Zuge eines Aufsteckvorgangs, sicher kontaktiert werden.

Das Funktionsmodul kann ein drahtloses Datenübertragungsmodul sein, beispielsweise ein RFID- oder Transponder-Modul.

Der Kunststoffformkörper kann vorgeformte Bereiche bzw. Vertiefungen 8 zur Führung und Fixierung flexibler elektrischer Leiter bzw. Kabel aufweisen, und auf diese Weise eine sichere Kabelführung gewährleisten.

Der Kunststoffformkörper kann mittels einer, beispielsweise genau einer, Schraubverbindung mit dem Gehäuse mechanisch gekoppelt werden.

Auf der Leiterplatte ist mindestens ein Leistungshalbleiterbauelement, beispielsweise ein insulated-gate bipolar Transistor (IGBT)-Modul, angeordnet, dem eine Andruckplatte zugeordnet ist, wobei die Andruckplatte in dem Kunststoffformkörper ausgebildet bzw. mittels des Kunststoffformkörpers gebildet ist. Andruckplatten ermöglichen durch Kraftbeaufschlagung eine verbesserte thermische Ankopplung des Leistungshalbleiterbauelements an einen zugehörigen Kühlkörper und sind in der Regel als eigenes Bauelement für ein jeweiliges Leistungshalbleiterbauelement zu bestücken. Durch Integration der Andruckplatte in den Kunststoffformkörper sinken die Bauelementkosten und der Montageaufwand wird reduziert.

Die Erfindung wird nachfolgend unter Bezugnahme auf die Zeichnungen detailliert beschrieben. Hierbei zeigt schematisch:
- Fig. 1: eine perspektivische Explosionsdarstellung eines Frequenzumrichters,
- Fig. 2: eine perspektivische Darstellung eines Kunststoffformkörpers des in Fig. 1 gezeigten Frequenzumrichters und
- Fig. 3: Funktionsmodulhaltemittel des in Fig. 2 gezeigten Kunststoffformkörpers.

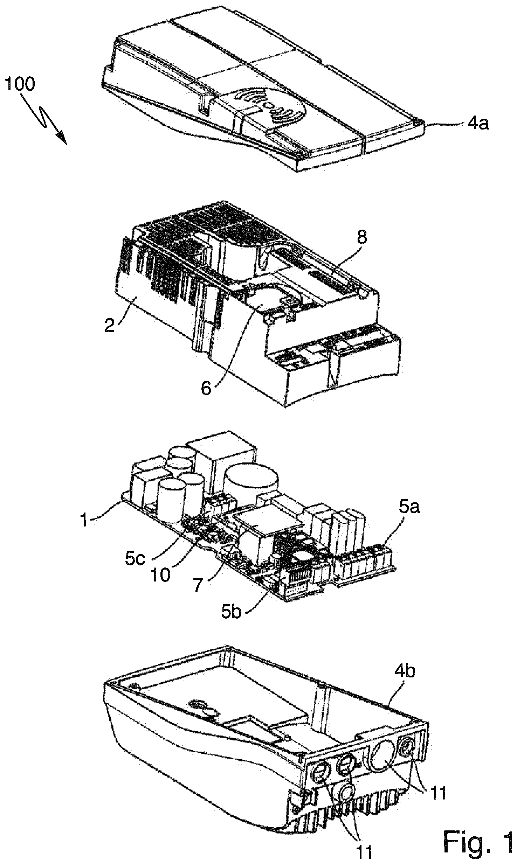

Fig. 1 zeigt eine perspektivische Explosionsdarstellung eines Frequenzumrichters 100.

Der Frequenzumrichter 100 weist ein Gehäuse umfassend ein Gehäuseoberteil bzw. einen Gehäusedeckel 4a aus Kunststoff und ein Gehäuseunterteil 4b aus Aluminiumdruckguss auf. Das Gehäuseunterteil 4b weist verschließbare Öffnungen 11 zur Kabeldurchführung auf.

Der Frequenzumrichter 100 weist weiter einen räumlich geformten Kunststoffformkörper 2 auf, der in einem fertig montierten Zustand des Frequenzumrichters 100 in das aus den Gehäuseteilen 4a und 4b gebildete Gehäuse eingesetzt ist.

Der Frequenzumrichter 100 weist weiter eine Leiterplatte 1 auf, auf der herkömmlich Bauelemente angeordnet sind, die zur Funktionssteuerung des Frequenzumrichters 100 dienen. Die Leiterplatte 1 weist auf ihrer dem Gehäuseoberteil 4a zuzuwendenden Seite verschiedene Bereiche auf, die eine gesundheitsgefährdende Spannung führen können und daher gegenüber Berührung zu schützen sind.

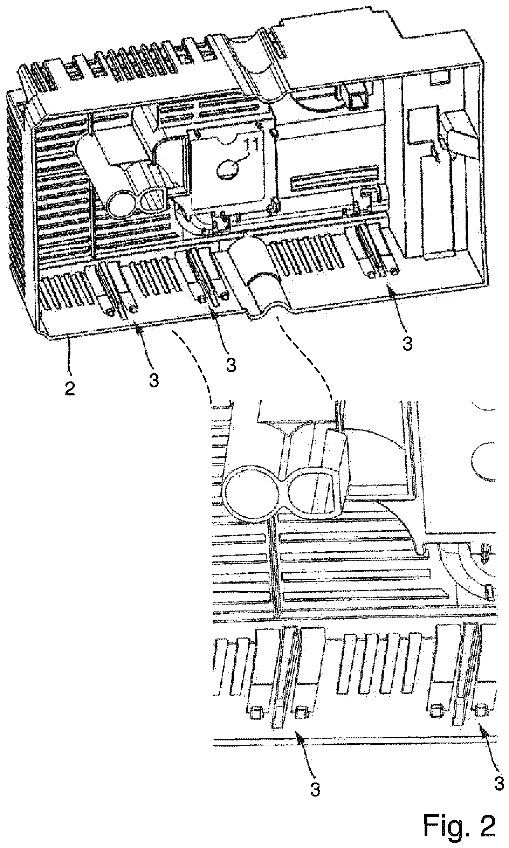

Der Kunststoffformkörper 2 weist eine Anzahl von rastend wirkenden Haltemitteln 3 (siehe Fig. 2) auf, die dazu ausgebildet sind, die Leiterplatte 1 im Kunststoffformkörper 2 lösbar mechanisch zu fixieren. Es versteht sich, dass auf der nicht sichtbaren Seite des Kunststoffformkörpers 2 an entsprechenden Positionen Haltemitteln 3 vorgesehen sein können. Die Leiterplatte 1 wird beispielsweise von unten in den Kunststoffformkörper 2 eingeschoben bzw. eingedrückt, bis die Leiterplatte 1 an den entsprechenden Leiterplattenbereichen in die jeweiligen Rast- bzw. Haltemittel 3 einrastet. Durch Aufweiten des Kunststoffformkörpers 2 lässt sich die Leiterplatte 1 wieder aus dem Kunststoffformkörper 2 entnehmen.

Solange der Kunststoffformkörper 2 und die Leiterplatte 1 in das Gehäuse bzw. das Gehäuseunterteil 4b eingesetzt sind, lässt sich der Kunststoffformkörper 2 nicht ausreichend aufweiten, um ihn von der Leiterplatte 1 nach oben abzuziehen, d.h. die Verbund aus Leiterplatte 1 und Kunststoffformkörper 2 lässt sich nur gemeinsam aus dem Gehäuseunterteil 4b entnehmen. Mit anderen Worten sind die Haltemittel 3 derart ausgebildet, dass ein Lösen der Leiterplatte 1 aus dem Kunststoffformkörper 2 nur dann möglich ist, wenn der Kunststoffformkörper 2 sowie die im Kunststoffformkörper 2 fixierte Leiterplatte 1 nicht in das Gehäuse bzw. das Gehäuseunterteil 4b eingesetzt sind.

Der Kunststoffformkörper 2 sowie die im Kunststoffformkörper 2 fixierte Leiterplatte 1 werden im Zuge eines Montagevorgangs zunächst in das Gehäuseunterteil 4b eingesetzt, wobei der Kunststoffformkörper 2 mittels einer einzelnen Schraubverbindung mit dem Gehäuseunterteil 4b verschraubt wird. Hierzu weist der Kunststoffformkörper 2 eine Durchgangsbohrung 11 (siehe Fig. 2) auf, durch die eine Gewindeschraube durchsteckbar ist, die in eine korrespondierende Gewindebohrung des Gehäuseunterteils 4b einschraubbar ist.

Anschließend wird der Deckel bzw. das Gehäuseoberteil 4a mit dem Gehäuseunterteil 4b verschraubt.

Bei geöffnetem Deckel bzw. fehlendem Gehäuseoberteil 4a deckt der Kunststoffformkörper 2 die gegenüber Berührung zu schützenden Bereiche der Leiterplatte 1 von oben ab, so dass diese Bereiche nicht berührbar sind. Eine Berührung von der Unterseite ist aufgrund des Gehäuseunterteils 4b ebenfalls ausgeschlossen.

Auf der Leiterplatte 1 sind mehrere Klemm- oder Steckverbinder 5a, 5b, 5c angeordnet, wobei die Haltemittel 3 derart über den Kunststoffformkörper 2 verteilt sind, dass sie die Leiterplatte 1 insbesondere im Bereich dieser Klemm- oder Steckverbinder 5a, 5b, 5c mechanisch fixieren, d.h. die Leiterplatte 1 in diesen Bereichen abstützen, so dass eine mechanische Verformung bei Kraftbeaufschlagung verhindert wird.

Der Kunststoffformkörper 2 ist derart mit Öffnungen versehen, dass die Klemm- oder Steckverbinder 5a, 5b, 5c für einen Benutzer bei abgenommenem Gehäuseoberteil 4a zugänglich sind.

Der Kunststoffformkörper 2 weist an seiner Oberseite Funktionsmodulhaltemittel 6 auf, die dazu ausgebildet sind, ein Funktionsmodul in Form eines radio-frequency identification (RFID)-Moduls 7 lösbar mechanisch zu fixieren. Bei dem RFID-Modul kann es sich beispielsweise um eine RFID-Transponderantenne oder einen RFID-Transponder mit zugehöriger Antenne handeln. Das RFID-Modul 7 ist in Fig. 1 aus Darstellungsgründen schematisch "schwebend" in seiner Montageposition dargestellt. Es versteht sich, dass das RFID-Modul 7, anders als in Fig. 1 dargestellt, in den Funktionsmodulhaltemitteln 6 fixiert ist.

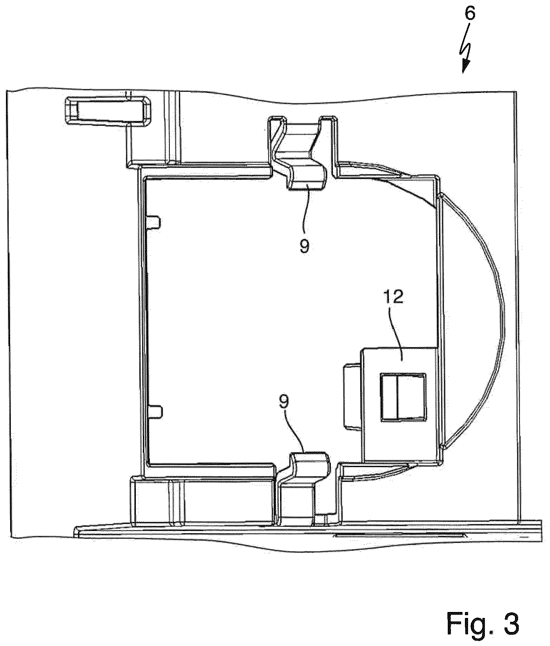

Die Funktionsmodulhaltemittel 6 weisen zur lösbaren Verrastung des RFID-Moduls 7 Rastmittel 9 auf (siehe Fig. 3).

Die Funktionsmodulhaltemittel 6 weisen weiter Führungsmittel 12 auf, die dazu ausgebildet sind, nicht näher dargestellte Kontaktstifte des Funktionsmoduls 7 derart zu führen, dass zugehörige Kontaktbereiche der Leiterplatte 1 bei der Montage sicher kontaktiert werden.

Auf der Leiterplatte 1 ist ein Leistungshalbleiterbauelement in Form eines IGBT-Moduls angeordnet, dem eine Andruckplatte 10 (in Fig. 1 aus Darstellungsgründen als einzelnes Bauelement dargestellt) zugeordnet ist, wobei die Andruckplatte 10 Bestandteil des Kunststoffformkörpers 2 ist. Andruckplatten ermöglichen durch Kraftbeaufschlagung eine verbesserte thermische Ankopplung des IGBT-Moduls an einen zugehörigen Kühlkörper (nicht dargestellt) und sind in der Regel als eigenes Bauelement für ein jeweiliges Leistungshalbleiterbauelement zu bestücken. Durch Integration der Andruckplatte 10 in den Kunststoffformkörper 2 sinken die Bauelementkosten und der Montageaufwand wird reduziert.

## Patentansprüche

1. Frequenzumrichter (100), aufweisend:
- eine Leiterplatte (1) mit gegenüber Berührung zu schützenden Bereichen,
- einen Kunststoffformkörper (2) mit Haltemitteln (3), die dazu ausgebildet sind, die Leiterplatte (1) im Kunststoffformkörper (2) lösbar mechanisch zu fixieren, wobei die gegenüber Berührung zu schützenden Bereiche der Leiterplatte (1) bei im Kunststoffformkörper (2) fixierter Leiterplatte (1) derart durch den Kunststoffformkörper (2) überdeckt sind, dass eine Berührung verhindert ist, und
- ein Gehäuse (4a, 4b), in das der Kunststoffformkörper (2) sowie die im Kunststoffformkörper fixierte Leiterplatte (1) eingesetzt sind,
- wobei auf der Leiterplatte (1) mindestens ein Leistungshalbleiterbauelement angeordnet ist, dem eine Andruckplatte (10) zugeordnet ist, wobei die Andruckplatte (10) in dem Kunststoffformkörper (2) ausgebildet ist.

2. Frequenzumrichter (100) nach Anspruch 1, **dadurch gekennzeichnet, dass** die Haltemittel einen Rastmechanismus aufweisen.

3. Frequenzumrichter (100) nach Anspruch 1 oder 2, **dadurch gekennzeichnet, dass** auf der Leiterplatte (1) mindestens ein lösbarer Klemm- oder Steckverbinder (5a, 5b, 5c) angeordnet ist, wobei die Haltemittel (3) derart angeordnet sind, dass sie die Leiterplatte (1) im Bereich des mindestens einen Klemm- oder Steckverbinders (5a, 5b, 5c) mechanisch fixieren.

4. Frequenzumrichter (100) nach einem der vorhergehenden Ansprüche, **dadurch gekennzeichnet, dass** die Haltemittel (3) derart ausgebildet sind, dass ein Lösen der Leiterplatte (1) aus dem Kunststoffformkörper (2) nur dann möglich ist, wenn der Kunststoffformkörper (2) sowie die im Kunststoffformkörper (2) fixierte Leiterplatte (1) nicht in das Gehäuse (4a, 4b) eingesetzt sind.

5. Frequenzumrichter (100) nach Anspruch 3 oder 4, **dadurch gekennzeichnet, dass** der Kunststoffformkörper (2) derart ausgebildet ist, dass die Klemm- oder Steckverbinder (5a, 5b, 5c) für einen Benutzer zugänglich sind.

6. Frequenzumrichter (100) nach einem der vorhergehenden Ansprüche, **dadurch gekennzeichnet, dass** der Kunststoffformkörper (2) Funktionsmodulhaltemittel (6) aufweist, die dazu ausgebildet sind, Funktionsmodule (7) lösbar mechanisch zu fixieren.

7. Frequenzumrichter (100) nach Anspruch 6, **dadurch gekennzeichnet, dass** die Funktionsmodulhaltemittel (6) Führungsmittel (12) aufweisen, die dazu ausgebildet sind, Kontaktstifte des Funktionsmoduls (7) derart zu führen, dass zugehörige Kontaktbereiche der Leiterplatte (1) kontaktiert werden.

8. Frequenzumrichter (100) nach einem der vorhergehenden Ansprüche, **dadurch gekennzeichnet, dass** das Funktionsmodul (7) ein drahtloses Datenübertragungsmodul ist, insbesondere ein RFID-Modul.

9. Frequenzumrichter (100) nach einem der vorhergehenden Ansprüche, **dadurch gekennzeichnet, dass** der Kunststoffformkörper (2) vorgeformte Bereiche (8) zur Führung und Fixierung flexibler elektrischer Leiter aufweist.

10. Frequenzumrichter (100) nach einem der vorhergehenden Ansprüche, **dadurch gekennzeichnet, dass** der Kunststoffformkörper (2) mittels einer Schraubverbindung mit dem Gehäuse (4a, 4b) mechanisch gekoppelt wird.

## Claims

1. Frequency converter (100), comprising:
- a printed circuit board (1) having regions to be protected against touch,
- a plastic moulded body (2) having holding means (3) configured to mechanically fix the printed circuit board (1) in the plastic moulded body (2) in a releasable manner, wherein, with the printed circuit board (1) fixed in the plastic moulded body (2), the regions of the printed circuit board (1) to be protected against touch are covered by the plastic moulded body (2) in such a way that touch is prevented, and
- a housing (4a, 4b), into which the plastic moulded body (2) and also the printed circuit board (1) fixed in the plastic moulded body are inserted,
- wherein at least one power semiconductor component is arranged on the printed circuit board (1), a pressure plate (10) being assigned to said at least one power semiconductor component, wherein the pressure plate (10) is formed in the plastic moulded body (2).

2. Frequency converter (100) according to Claim 1, **characterized in that** the holding means comprise a latching mechanism.

3. Frequency converter (100) according to Claim 1 or 2, **characterized in that** at least one releasable clamping or plug connector (5a, 5b, 5c) is arranged on the printed circuit board (1), wherein the holding means (3) are arranged in such a way that they mechanically fix the printed circuit board (1) in the region of the at least one clamping or plug connector (5a, 5b, 5c).

4. Frequency converter (100) according to any of the preceding claims, **characterized in that** the holding means (3) are configured in such a way that releasing the printed circuit board (1) from the plastic moulded body (2) is possible only if the plastic moulded body (2) and also the printed circuit board (1) fixed in the plastic moulded body (2) are not inserted into the housing (4a, 4b) .

5. Frequency converter (100) according to Claim 3 or 4, **characterized in that** the plastic moulded body (2) is configured in such a way that the clamping or plug connectors (5a, 5b, 5c) are accessible to a user.

6. Frequency converter (100) according to any of the preceding claims, **characterized in that** the plastic moulded body (2) comprises function module holding means (6) configured to mechanically fix functional modules (7) in a releasable manner.

7. Frequency converter (100) according to Claim 6, **characterized in that** the functional module holding means (6) comprise guide means (12) configured to guide contact pins of the functional module (7) in such a way that associated contact regions of the printed circuit board (1) are contacted.

8. Frequency converter (100) according to any of the preceding claims, **characterized in that** the functional module (7) is a wireless data transmission module, in particular an RFID module.

9. Frequency converter (100) according to any of the preceding claims, **characterized in that** the plastic moulded body (2) comprises preformed regions (8) for guiding and fixing flexible electrical conductors.

10. Frequency converter (100) according to any of the preceding claims, **characterized in that** the plastic moulded body (2) is mechanically coupled to the housing (4a, 4b) by means of a screw connection.

## Revendications

1. Convertisseur de fréquence (100), comprenant :
- une carte de circuit imprimé (1) comportant des zones à protéger contre les contacts,
- un corps moulé en plastique (2) comportant des moyens de maintien (3) qui sont conçus pour fixer mécaniquement de manière amovible la carte de circuit imprimé (1) dans le corps moulé en plastique (2), dans lequel les zones de la carte de circuit imprimé (1) à protéger contre les contacts sont recouvertes par le corps moulé en plastique (2) lorsque la carte de circuit imprimé (1) est fixée dans le corps moulé en plastique (2) de manière à empêcher tout contact, et
- un boîtier (4a, 4b) dans lequel sont insérés le corps moulé en plastique (2) et la carte de circuit imprimé (1) fixée dans le corps moulé en plastique,
- dans lequel au moins un composant semi-conducteur de puissance, auquel est associée une plaque de pression (10), est disposé sur la carte de circuit imprimé (1), dans lequel la plaque de pression (10) est formée dans le corps moulé en plastique (2).

2. Convertisseur de fréquence (100) selon la revendication 1, **caractérisé en ce que** les moyens de maintien comprennent un mécanisme à encliquetage.

3. Convertisseur de fréquence (100) selon la revendication 1 ou 2, **caractérisé en ce qu'**au moins un connecteur à serrage ou à enfichage amovible (5a, 5b, 5c) est disposé sur la carte de circuit imprimé (1), dans lequel les moyens de maintien (3) sont disposés de telle manière qu'ils fixent mécaniquement la carte de circuit imprimé (1) dans la zone dudit au moins un connecteur à serrage ou à enfichage (5a, 5b, 5c).

4. Convertisseur de fréquence (100) selon l'une des revendications précédentes, **caractérisé en ce que** les moyens de maintien (3) sont conçus de telle manière qu'une séparation de la carte de circuit imprimé (1) hors du corps moulé en plastique (2) ne soit possible que lorsque le corps moulé en plastique (2), ainsi que la carte de circuit imprimé (1) fixée dans le corps moulé en plastique (2), ne sont pas insérés dans le boîtier (4a, 4b).

5. Convertisseur de fréquence (100) selon la revendication 3 ou 4, **caractérisé en ce que** le corps moulé en plastique (2) est conçu de telle manière que les connecteurs à serrage ou à enfichage (5a, 5b, 5c) soient accessibles à un utilisateur.

6. Convertisseur de fréquence (100) selon l'une des revendications précédentes, **caractérisé en ce que** le corps moulé en plastique (2) comporte des moyens de maintien de modules fonctionnels (6) qui sont conçus pour fixer mécaniquement de manière amovible des modules fonctionnels (7).

7. Convertisseur de fréquence (100) selon la revendication 6, **caractérisé en ce que** les moyens de maintien de modules fonctionnels (6) comportent des moyens de guidage (12) qui sont conçus pour guider des broches de contact du module fonctionnel (7) de manière à établir un contact avec des zones de contact associées de la carte de circuit imprimé (1).

8. Convertisseur de fréquence (100) selon l'une des revendications précédentes, **caractérisé en ce que** le module fonctionnel (7) est un module de transmission de données sans fil, en particulier un module RFID.

9. Convertisseur de fréquence (100) selon l'une des revendications précédentes, **caractérisé en ce que** le corps moulé en plastique (2) comporte des zones préformées (8) permettant de guider et de fixer des conducteurs électriques souples.

10. Convertisseur de fréquence (100) selon l'une des revendications précédentes, **caractérisé en ce que** le corps moulé en plastique (2) est couplé mécaniquement au boîtier (4a, 4b) au moyen d'un raccord à vis.
